# EUROPEAN PATENT APPLICATION

(11) **EP 1 385 013 A1**
(43) Date of publication of application: **28.01.2004**
(21) Application number: 02255123.8
(22) Date of filing: 22.07.2002
(51) Int. Cl.: G01R 15/14, G01R 19/25

(54) **Multifunction intelligent electronic device and method**

(71) Applicant: GENERAL ELECTRIC COMPANY, Schenectady, NY 12345 (US)
(72) Inventor: Gamvrelis, Metaxas, Calgary, AB T2W 0C6 (CA); Poda, Sigismund, Calgary, AB T3J 3X6 (CA)
(74) Representative: Pedder, James Cuthbert

(57) **Abstract**

A multifunction intelligent electronic device (IED) 10 monitors and reports signals including utility metering, harmonic spectrum, digital fault recording (DFR), and supervisory control and data acquisition (SCADA) functions. The IED includes an A.C. subsystem (82) , a digital signal processing system (84) for processing data received by the A.C. subsystem, and a microprocessor system (86) for controlling various functions of the IED. The IED is capable of direct connection to a field sensor on a distribution circuit. The A.C. subsystem (82) of the IED includes a plurality of transformers (T1, T2, T3), each transformer operating with respect to one phase (phase 1, phase 2, phase 3) of a power line, and a plurality of switching circuits (U2, U3, U4), each switching circuit is coupled to a respective transformer and capable of switching to first or second positions depending on whether the current at the primary circuit of a respective transformer is in a metering range or in an overcurrent (DFR) range.

## Description

This invention relates to a method and apparatus for monitoring electric signal on a distribution circuit and, more particularly, it relates to a multifunction intelligent electronic device (IED) for performing utility metering, harmonic content, digital fault recording (DFR), and supervisory control and data acquisition (SCADA) functions.

Electric utility power must be monitored and controlled to ensure proper operational performance. It must also be controlled in real-time to permit switching for maintenance, improved utilization and efficiency, and in response to situations that may compromise safety. Electric utility power must also be metered at various points for revenue purposes and also to ensure that circuits are optimally loaded. With the proliferation of computer equipment and electronic controllers for motor drivers, utility circuits are littered with unwanted signals called "harmonics". These harmonics must be identified and controlled to prevent equipment disturbances and failures. As these metered and harmonic signals are relatively small in magnitude, they must be reported with high precision within a range that is typically termed as the "nominal" range. Further, power lines are subjected to various disturbances as a result of natural and environmental effects such as lightning, high winds, ice load, rodents, birds, etc. Man made circumstances such as vehicular accidents further add to these disturbances.

In contrast to harmonic and metered signals, disturbance signals are usually large in magnitude and occur within a range that is typically termed as the "overcurrent" range. The "overcurrent" range spans from "2 - 42" times the "nominal range". Electric utilities require equipment that can accurately, safely, and economically control power lines in addition to recording and reporting both metering and disturbance information.

With respect to metering and DFR functions, known methods typically call for separate equipment units to carry out utility metering, harmonic spectrum and disturbance functions due to the inability of an integrated device to perform multiple functions in the required range of measurement. Prior methods accomplished utility metering and harmonic spectrum functions with metering devices, while disturbance recording functions were accomplished using a different apparatus such as a digital fault recorder (DFR). These devices interfaced to the power lines via potential transformers (PTs) and current transformers (CTs). Employing multiple devices to perform a plurality of functions requires more installation room and increased engineering, commissioning, and maintenance costs.

Accordingly, the exemplary apparatus described herein provides a multifunction intelligent electronic device (IED) and method for performing such functions as utility metering, harmonic content, digital fault recording (DFR), and SCADA functions over an entire current range for multiple primary equipment, such as for example, communication devices, and equipment having a plurality of digital inputs, transducerless AC analog inputs to name a few. The IED may be directly connected to voltage and current sensors on a distribution circuit to monitor electric signals.

Input data from field transformers, such as current transformers (CTs) and potential transformers (PTs), is received by an A.C. input sub-system which is coupled to field transformers through a field interface terminal unit. the A.C. input subsystem is coupled to a digital signal processor (DSP) system to process the data received from the field transformers for monitoring and reporting utility metering, harmonic content, and DFR functions. The DSP subsystem converts the analog input signals into digital representations using a MUX/ A/D converter/ Signal conditioning unit. The DSP subsystem include first and second signal processing devices which operate under the control of a primary microprocessor to control various functions of the IED apparatus including the switching functions of the A.C. subsystem in overcurrent and metering ranges. A second microprocessor works with the primary microprocessor and controls the monitoring and reporting of SCADA functions.

Each transformer further includes a normal mode surge and impulse protection circuitry, and a crowbar protection circuit for protection against signals that are higher in positive polarity than a supply voltage +V, and signals that have more negative polarity than a supply voltage -V. Switching circuits of the IED perform appropriate switching functions depending on whether the field current in a primary circuit of a respective transformer is within a metering range or an overcurrent range. A microprocessor controls the functioning of each of the switching units in addition to providing such functions as analog-to-digital conversion, multiplexing functions, et cetera.

In one aspect, the present invention provides a multifunction apparatus for monitoring and reporting electric signals on a distribution circuit including a first system for receiving input data from a field transformer; a digital signal processor (DSP) system coupled to the first system; a microprocessor system coupled to the DSP system; and the first system in combination with the DSP system and the microprocessor system functioning to perform utility, harmonic content, and distributed fault recording (DFR) functions. The first system preferably includes a plurality of transformers, each transformer operating with respect to one phase of the distribution circuit; and a plurality of switching circuits, each circuit coupled to a respective transformer and further adapted to switch to a first position or a second position depending on whether the current flowing through a primary circuit of a respective transformer is in a metering range or an overcurrent range. circuit assembly for providing normal mode surge and impulse protection. The circuit assembly preferably includes a metal oxide varistor (MOV) and a capacitor. Also, a secondary circuit of each transformer includes a diode mirror circuit for providing crowbar protection against signals that are higher in polarity than a supply voltage.

In another aspect, the present invention provides a multifunction apparatus having an A.C. subsystem which includes a plurality of transformers and a switching circuit associated with each transformer, a method for monitoring and reporting electric signals by electrically coupling the apparatus to a field sensor; feeding data from the field sensor to the A.C. subsystem; causing each switching circuit to switch to a first position or a second position depending on whether the current flowing through a primary circuit of a respective transformer is in a metering range or an overcurrent range. The method further includes providing a digital signal processor (DSP) to process data received by the A.C. subsystem; providing a first microprocessor for controlling software applications of the apparatus; and providing a second microprocessor for performing supervisory control and data acquisition (SCADA) functions. The method also includes providing a normal mode surge and impulse protection circuit between the field sensor and the primary circuit of each transformer; and controlling the A.C. subsystem and the DSP by the first microprocessor. The method also provides crowbar protection against signals that are higher in polarity than a supply voltage.

In yet another aspect, the present invention provides a multifunction apparatus for monitoring and reporting electric signals, including a first subsystem for receiving input data from a field sensor, the subsystem having a plurality of transformers, a plurality of switching circuits, each switching circuit capable of switching to a first position or a second position depending on whether the current flowing in a primary circuit of a respective transformer is in a metering range or an overcurrent range; a digital signal processor means for processing data received by the first subsystem; and a microprocessor means for controlling the first subsystem and the DSP means.

The invention will now be described in greater detail, by way of example, with reference to the drawings, in which:-
FIGURE 1 shows a high level block diagram embodying the device of the present invention;
FIGURE 2 illustrates a detailed circuit diagram of the multifunction intelligent electronic device of the present invention for measuring signals of a three-phase power line;
FIGURE 3 illustrates a Digital Signal Processor (DSP) sub-system of the present invention of Figure 1;
FIGURE 4 depicts communications between the DSP sub-system, as shown in Figure 3, and the main processor of the device.

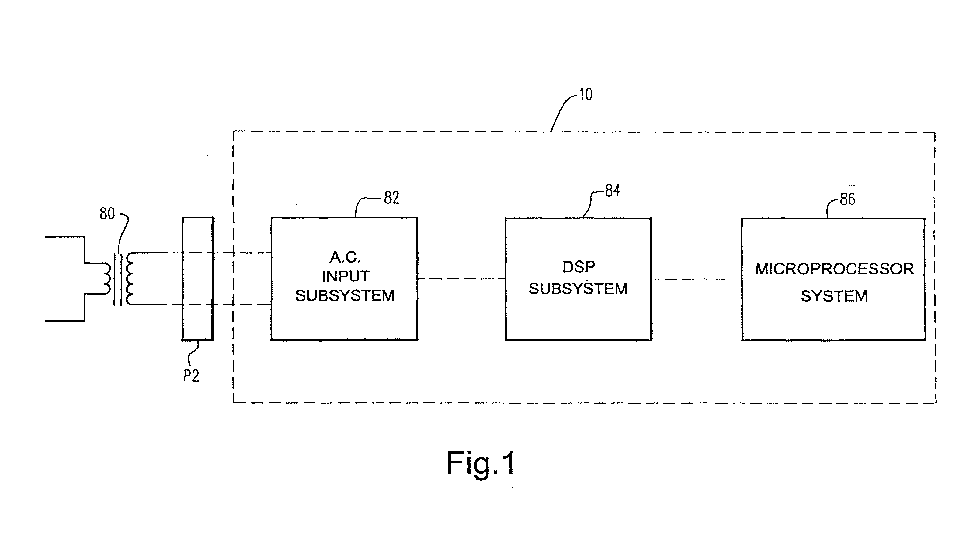

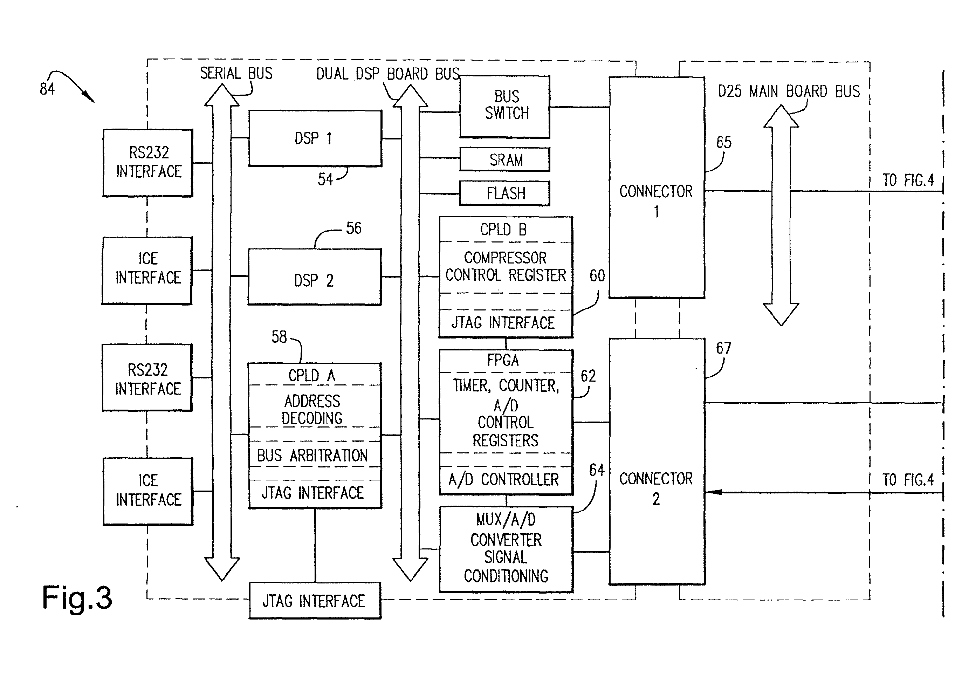

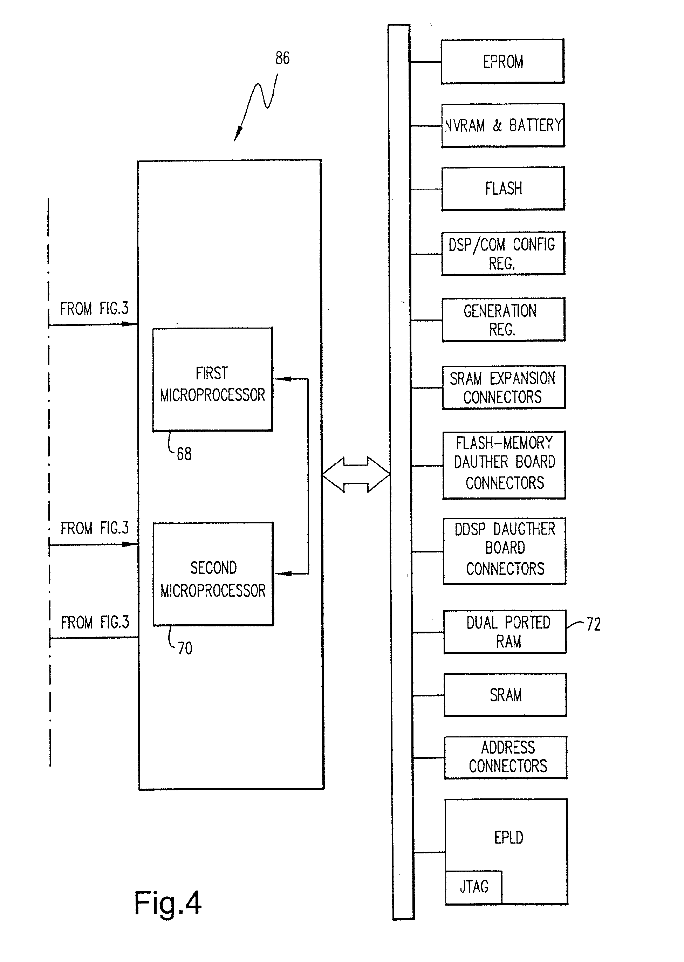

Referring now to FIG. 1, there is shown a high level block diagram of the IED according to the present invention. IED 10 generally includes an A.C. input subsystem 82, a digital signal processor (DSP) subsystem 84, and a microprocessor system 86. IED 10 is coupled to a field transformer 80 through a field interface terminal block P2. The field transformer 80 may be a current transformer (CT) or a potential transformer (PT). Input data from the field transformer 80 is received by an A.C. input sub-system 82 which is responsible for monitoring utility metering, harmonic content, and digital fault recording (DFR) functions. The DSP subsystem 84 includes first and second DSP devices 54, 56 (Figure 3) one of the devices being responsible for monitoring the functioning of the A.C. subsystem 82 while the other is responsible for monitoring DFR functions. A microprocessor system 86 controls the overall operation of the IED device 10 including the functioning of the A.C. subsystem 82 and the DSP 84. The microprocessor system 86 includes microprocessors 68, 70 (Figure 4). Microprocessor 70 operates under the control of microprocessor 68 to perform SCADA functions.

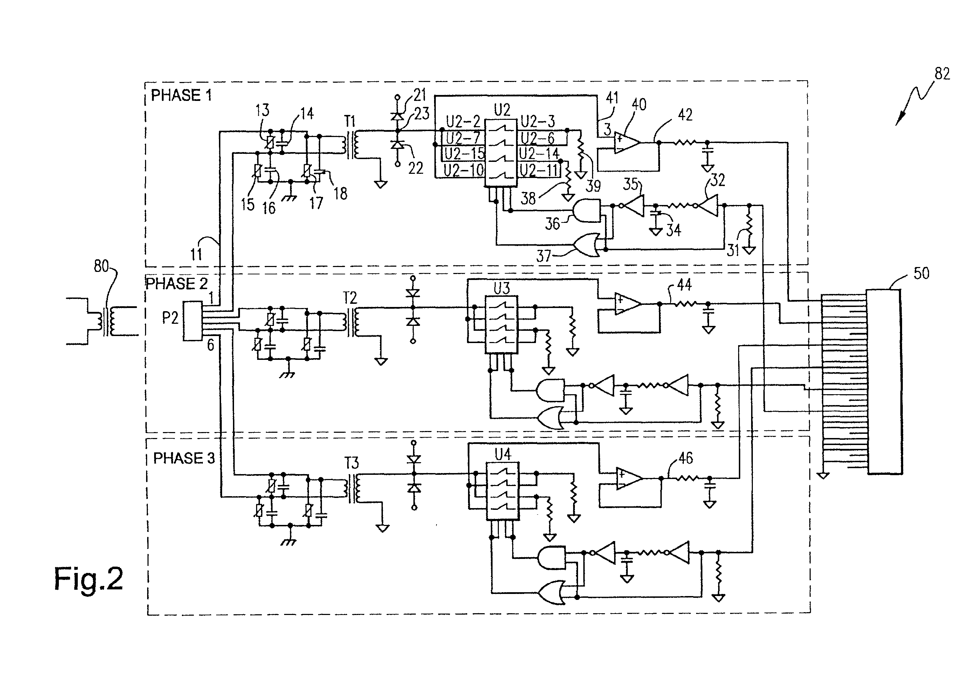

Referring now to Figure 2, there is shown a detailed circuit diagram 82 of the A.C. input sub-system 82 of the multifunction IED 10. An input signal from a field transformer 80 is received in the terminal block P2 through the first terminal block position P2-1. The received signal enters conductor 11 and exits through the second terminal block position P2-2 where conductor 11 terminates. It should be noted that field transformer 80 need not necessarily be terminated at the terminal block P2, rather the connections from transformer 80 may pass through to the primary winding of transformer T1. Metal oxide varistor (MOV) 13, and capacitor 14 provide normal mode surge and impulse protection to IED 10 from surges in a respective phase of the power line. A circuit formed by MOVs 15, 17, and capacitors 16, 18 provide common mode surge and impulse protection to circuit created by conductor 11. In the exemplary embodiment of Figure 2, the A.C. input subsystem 82 is discussed with respect to three phases, generally identified as phase 1, phase 2, and phase 3, to explain the inventive concept without ambiguity. The present invention is actually capable of operating on up to 14 phases of a distribution circuit.

Conductor 11 couples to the primary winding of transformer T1. Current in the primary winding of transformer T1 induces a magnetic field causing a signal to appear in the secondary winding. Supply voltages +V and -V are provided to diodes 21, 22, respectively. Diodes 21, 22 meet the second winding at junction 23 and provide crowbar protection against signals that are higher in positive and negative polarities than supply voltages +V and -V, respectively. A switching integrated circuit (SIC) U2 is connected to the secondary winding and controlled by DSP 84 (Figure 3). DSP 84 is coupled to the AC subsystem 82 through an interface connector 50. DSP 84 is controlled by at least one of the microprocessors 68, 70 (Figure 4). DSP 84 converts analog signals 42, 44, 46 to digital signals using a MUX/ A/D converter/signal conditioning unit ("MAS") 64 (Figure 3). The digital signals are then passed to DSP1 54 (Figure 3) which then writes into a compressor register located in CPLD B 60, which may be an electrical programmable logic device, resulting in a control signal at device 32 of Figure 2. The control signal at device 32 is high indicating compression mode when the analog signals 42, 44, 46 are in the overcurrent range. The control signal at device 32, however, is low when analog signals 42, 44, 46 are in the metering range.

The SIC U2 having pins U2-10 & U2-11 and pins U2-14 & U2-15 engages resistance 38 into the circuit when the field current flowing through the primary winding of T1 is in the metering range, thereby developing a voltage at pin U2-10, the voltage being proportional to the current flowing in the primary winding of T1. When the field current flowing through the primary winding of T1 is in the overcurrent (DFR) range, resistance 39 is engaged by closing contacts U2-2 & U2-3, U2-6 & U2-7 and opening contacts U2-14 & U2-15, U2-10 & U2-11, thereby developing a voltage at pin U2-7, the voltage being proportional to the current flowing in the primary winding of transformer T1. The voltage developed at pin U2-7 or pin U2-10 of SIC U2 is now presented at pin 3 of the operational amplifier 40 which buffers the voltage to provide a signal identified at 42. The signal identified at 42 is multiplexed with similar signals identified at 44, 46 with respect to other phases of the power line. The multiplexed signals are converted to digital signals by MAS 64 of the DSP 84.

The DSP 84 includes two digital signal processors (DSP1 54 & DSP2 56). DSP 84 further includes DSP I/O and DSP DFR applications in software form. One of DSP1 54 or DSP2 56 may be dedicated to the collection of AC input data, while the other may be responsible for performing DFR functions. The DSP I/O application runs on DSP1 54 and receives sampled data from MAS 64, processes the received sampled data, and reports the processed data to processor 68 (Figure 4) through a dual port memory 72 (Figure 4). An interrupt routine running on DSP 84 receives samples from the MAS 64 and copies them to primary input buffers. Upon collecting data pertaining to a complete cycle, an interrupt routine of processor 68 sets a flag to initiate a main processing routine by correcting the magnitude component of the data using correction factors identified by a user via a user interface to offset manufacturing tolerances in transformer 80. The corrected data is then transformed into frequency domain applying a Discrete Fourier Transform (DFT). Phase correction is performed on the transformed data to compensate for the phase shift introduced by analog multiplexers of MAS 64. Total Harmonic Distortion (THD), Root-Mean Square (RMS) values for currents and voltages, active, reactive, and apparent power, power factor, energy values, and symmetrical components are then computed by DSP1 54, DSP2 56 under the control of processor 68. If a 60/50 Hz filtering is enabled, then these values are computed using the fundamental frequency component only. However, if 60/50 Hz filtering is disabled, then these values are computed using all DFT series coefficients. The computed values are then copied into a dual-port memory 72 and an interrupt to processor 68 is issued. The sampling period is then adjusted and processing ceases until the interrupt routine sets the flag again, thus indicating that another cycle of data is ready for processing.

The DSP DFR application runs on DSP2 56 and receives sample data from the A/D converter of MAS 64. The DSP2 56 applies time stamps in the form of a Real Time Clock and reports the timestamps to processor 68 for further processing by the DFR Data Translation Application (DFR-DTA) residing in processor 68. The DSP-DFR application communicates with the DFR-DTA application through shared memory accessible to both the DSP DFR and processor 68 via interprocessor communication subsystem (ICOM) software layer (not shown). ICOM includes a component resident in the code for processor 68 and a mirrored component resident in DSP2 56. The DSP DFR application functionalities includes boot and control of the DSP DFR processor in DSP2 56, providing communication functions with processor 68 (i.e., provide the DSP side of ICOM subsystem, now referred to as ICOM-DSP), providing communication functions with the DFR DTA application running on processor 68 according to the DFR DTA/DSP Message Protocol, reading data samples on the A.C. analog inputs and providing a time stamp to each of the analog inputs received by the A.C. subsystem 82, and transferring data samples to the shared memory to be available to the DFR DTA application. IED 10 is further capable of monitoring SCADA functions under the control of processor 70 (Figure 4). Processor 70 communicates with processor 68 to distribute its data and to receive control operation commands. Thus, IED 10 of the present invention accomplishes utility metering, harmonic content, and DFR functions while maintaining SCADA functionality and performance.

The operation of the A.C. sub-system of the IED is explained with respect to a power line consisting of three phases as illustrated in FIGURE 2. Circuit operation with respect to phase 1 is explained in detail as set forth above. Operation of phases 2 and 3 are similar to the operation of phase 1. The advantages of IED 10 include its ability to accurately report in the metering as well as overcurrent(DFR) ranges. Further, the IED 10 interfaces with all popular field transformers, has low input impedance, wide frequency response and operating temperature ranges. It is further immune to current overloads, and electromagnetic interference. The IED accomplishes high accuracy metering, harmonic spectrum, and wide dynamic range DFR functions while maintaining SCADA functionality and performance.

For the sake of good order, various aspects of the invention are set out in the following clauses: -
1. A multifunction apparatus (10) for monitoring and reporting electric signals on a distribution circuit, comprising:
   a first system (82) for receiving input data from a field transformer;
   a digital signal processor (DSP) system (84) coupled to said first system;
   a microprocessor system (86) coupled to said DSP system; and
   said first system in combination with said DSP system and said microprocessor system functioning to perform utility, harmonic content, and distributed fault recording (DFR) functions.
2. The apparatus of clause 1 wherein said first system (82) comprises:
   a plurality of transformers (T1, T2, T3) each transformer operating with respect to one phase of the distribution circuit; and
   a plurality of switching circuits (U2, U3, U4), each circuit coupled to a respective transformer (T1, T2, T3) and further adapted to switch to a first position or a second position depending on whether the current flowing through a primary circuit of a respective transformer is in a metering range or an overcurrent range.
3. The apparatus of clause 2 further comprises a circuit assembly for providing normal mode surge and impulse protection.
4. The apparatus of clause 3 wherein said circuit assembly comprises a metal oxide varistor (MOV) (13) and a capacitor (14).
5. The apparatus of clause 2 further comprises a circuit assembly (15, 16, 17, 18) for providing common mode surge and impulse protection.
6. The apparatus of clause 4 wherein a secondary circuit of each transformer includes a diode mirror circuit (21, 23) for providing crowbar protection against signals that are higher in polarity than a supply voltage.
7. In a multifunction apparatus (10) having an A.C. subsystem (82) which includes a plurality of transformers (T1, T2, T3) and a switching circuit (U2, U3, U4) associated with each transformer, a method for monitoring and reporting electric signals comprising the steps of:
   electrically coupling the apparatus (10) to a field sensor;
   feeding data from said field sensor to the A.C. subsystem (8)2;
   causing each said switching circuit to switch to a first position or a second position depending on whether the current flowing through a primary circuit of a respective transformer is in a metering range or an overcurrent range.
8. The method of clause 7 further comprising:
   providing a digital signal processor (DSP) (84) to process data received by said A.C. subsystem;
   providing a first microprocessor (68) for controlling software applications of the apparatus; and
   providing a second microprocessor (70) for performing supervisory control and data acquisition (SCADA) functions.
9. The method of clause 8 further comprising:
   providing a normal mode surge and impulse protection circuit (13, 14) between the field sensor and the primary circuit of each transformer; and
   controlling said A.C. subsystem and said DSP by said first microprocessor (68).
10. The method of clause 9 further comprises providing a crowbar protection against signals that are higher in polarity than a supply voltage.
11. The method of clause 10 wherein crowbar protection is provided by a diode mirror circuit (21, 23).
12. A multifunction apparatus (10) for monitoring and reporting electric signals, comprising:
   a first subsystem (82) for receiving input data from a field sensor, said subsystem having a plurality of transformers (T1, T2, T3), a plurality of switching circuits (U2, U3, U4), each switching circuit capable of switching to a first position or a second position depending on whether the current flowing in a primary circuit of a respective transformer is in a metering range or an overcurrent range;
   a digital signal processor means (84) for processing data received by said first subsystem; and
   a microprocessor means (86) for controlling said first subsystem and said DSP means.
13. The apparatus of clause 12 further comprises a circuit assembly (13, 14) for providing normal mode surge and impulse protection.
14. The apparatus of clause 13 wherein said circuit assembly comprises a metal oxide varistor (MOV) and a capacitor.
15. The apparatus of clause 14 wherein a secondary circuit of each transformer includes a diode mirror circuit (21, 23) for providing crowbar protection against signals that are higher in polarity than a supply voltage.

## Claims

1. A multifunction apparatus (10) for monitoring and reporting electric signals on a distribution circuit, comprising:
a first system (82) for receiving input data from a field transformer;
a digital signal processor (DSP) system (84) coupled to said first system;
a microprocessor system (86) coupled to said DSP system; and
said first system in combination with said DSP system and said microprocessor system functioning to perform utility, harmonic content, and distributed fault recording (DFR) functions.

2. The apparatus of claim 1 wherein said first system (82) comprises:
a plurality of transformers (T1, T2, T3) each transformer operating with respect to one phase of the distribution circuit; and
a plurality of switching circuits (U2, U3, U4), each circuit coupled to a respective transformer (T1, T2, T3) and further adapted to switch to a first position or a second position depending on whether the current flowing through a primary circuit of a respective transformer is in a metering range or an overcurrent range.

3. The apparatus of claim 2 further comprises a circuit assembly for providing normal mode surge and impulse protection.

4. The apparatus of claim 3 wherein said circuit assembly comprises a metal oxide varistor (MOV) (13) and a capacitor (14).

5. A method of monitoring and reportin electric signals in a multifunction apparatus (10) having an A.C. subsystem (82)which includes a plurality of transformers (T1, T2, T3) and a switching circuit (U2, U3, U4) associated with each transformer, the method comprising the steps of:
electrically coupling the apparatus (10) to a field sensor;
feeding data from said field sensor to the A.C. subsystem (82);
causing each said switching circuit to switch to a first position or a second position depending on whether the current flowing through a primary circuit of a respective transformer is in a metering range or an overcurrent range.

6. The method of claim 5 further comprising:
providing a digital signal processor (DSP) (84) to process data received by said A.C. subsystem;
providing a first microprocessor (68) for controlling software applications of the apparatus; and
providing a second microprocessor (70) for performing supervisory control and data acquisition (SCADA) functions.

7. The method of claim 6 further comprising:
providing a normal mode surge and impulse protection circuit (13, 14) between the field sensor and the primary circuit of each transformer; and
controlling said A.C. subsystem and said DSP by said first microprocessor (68).

8. A multifunction apparatus (10) for monitoring and reporting electric signals, comprising:
a first subsystem (82) for receiving input data from a field sensor, said subsystem having a plurality of transformers (T1, T2, T3), a plurality of switching circuits (U2, U3, U4), each switching circuit capable of switching to a first position or a second position depending on whether the current flowing in a primary circuit of a respective transformer is in a metering range or an overcurrent range;
a digital signal processor means (84) for processing data received by said first subsystem; and
a microprocessor means 86 for controlling said first subsystem and said DSP means.

9. The apparatus of claim 8 further comprises a circuit assembly (13, 14) for providing normal mode surge and impulse protection.

10. The apparatus of claim 9 wherein said circuit assembly comprises a metal oxide varistor (MOV) and a capacitor.
